# DEMANDE DE BREVET EUROPEEN

(11) **EP 1 357 591 A2**
(43) Date de publication de la demande: **29.10.2003**
(21) Numéro de dépôt: 03290910.3
(22) Date de dépôt: 11.04.2003
(51) Int. Cl.: H01L 21/98, H01L 25/065, H01L 23/66

(54) **Procédé d'assemblage de composants électriques sur une plaque de base d'unité terminale radiofréquence**

(30) Priorité: 22.04.2002 FR 0204990
(71) Demandeur: ALCATEL, 75008 Paris (FR)
(72) Inventeur: Rivière, Fabrice, 76260 Eu (FR)
(74) Mandataire: Sciaux, Edmond

(57) **Abrégé**

Un procédé d'assemblage consiste i) à prendre une plaque de base (1) munie, en des endroits choisis, de plots saillants (2,3) définissant entre eux au moins des premières zones de dimensions choisies, ii) à déposer des moyens d'adhésion (8) dans certaines au moins des premières zones, iii) à déposer un substrat choisi (6) dans certaines au moins des premières zones, iv) à appliquer une pression choisie simultanément sur les substrats (6) pour les solidariser à la plaque de base (1) à l'aide des moyens d'adhésion (8), et v) à solidariser des composants électroniques (9) au sommet de certains au moins des plots (3), puis à établir des liaisons électriques (11) entre les composants (9) et les substrats (6) situés dans leur voisinage.

## Description

L'invention concerne le domaine des télécommunications, et plus précisément celui de l'assemblage de composants sur une plaque de base d'unité terminal radiofréquence.

Certains terminaux (ou stations de base) radiofréquence, par exemple à faisceaux hertziens de transmission ou de distribution pour une boucle locale radio (BLR), appartiennent à des installations de télécommunications hyperfréquence (ou micro-onde), de type « point à point » ou « point - multipoint » (« multicast » ou « concast »). Ces terminaux utilisent généralement des plaques de base métalliques (plus connues sous le nom anglais de « soleplate »), sur lesquelles sont notamment implantés des couches conductrices, généralement en alumine, des substrats et des composants électroniques, tels que des circuits intégrés hyperfréquence millimétriques, plus connus sous l'acronyme anglais MMIC (pour « Millimetrics Microwave Integrated Circuits »).

Pour réaliser ce type d'assemblage, deux solutions ont été proposées. La première solution consiste tout d'abord à déposer, en des endroits choisis de la plaque de base métallique, de la pâte adhésive ou des portions de film de colle époxy, puis à placer séquentiellement aux endroits encollés, selon un modèle prédéfini, des substrats ou des couches conductrices, ces dernières constituées de plaques d'alumine portant un dépôt métallique sur leur face libre. Pour assurer une solidarisation de qualité des substrats et couches d'alumine à la plaque de base, on leur applique une pression, de façon individualisée, soit à l'aide de clips placés manuellement, soit à l'aide d'outils complexes dédiés. Du fait de la pression exercée, l'adhésif à fréquemment tendance à déborder dans les zones non encollées destinées à recevoir les MMICs. Cet excès d'adhésif doit alors être retiré manuellement, zone après zone. On vient ensuite placer dans chacune des zones précitées un espaceur ou entretoise (« stub »), puis, on fixe, par collage, un MMIC au sommet de chaque espaceur. L'assemblage se termine par l'établissement de liaisons électriques entre les MMICs et les substrats et/ou couches d'alumine qui les entourent.

Cette solution n'est pas satisfaisante dans la mesure où, d'une première part, les positionnements doivent s'effectuer sous le contrôle d'un opérateur via un instrument optique, tel qu'un microscope binoculaire, d'une seconde part, le mode individualisé d'application de la pression ne garantie pas une distribution de pression homogène, et peut nécessiter des reprises pour retirer localement des excès d'adhésif et pour replacer des substrats et/ou des couches d'alumine mal positionnés, et d'une troisième part, le positionnement des MMICs est onéreux puisqu'il nécessite au préalable l'implantation d'espaceurs dans les zones non encollées.

La seconde solution consiste à partir d'une plaque de base sur laquelle un unique substrat a été pré-encollé, puis à graver ou usiner le substrat pour définir les zones d'implantation des MMICs. Cette solution n'est pas non plus satisfaisante dans la mesure où elle ne permet ni l'intégration de régions de transition à guide d'onde hyperfréquence (plus connues sous l'acronyme anglais MWT, pour « Microwave Waveguide Transition »), ni l'obtention de plans de masse de grande qualité.

Le document **WO 99 17367** décrit un dispositif comportant :
- un plot saillant, usiné dans une plaque de base, pour surélever une puce ;
- un circuit imprimé sur un substrat isolant collé sur la plaque de base, et entourant au moins partiellement le plot saillant, pour permettre de réaliser liaisons avec la puce ;
- et un enrobage de résine.
Un espace est laissé entre le circuit imprimé et le plot saillant supportant la puce, pour permettre le passage de la résine tout autour du plot afin d'obtenir un bon enrobage.
Ce dispositif a pour inconvénient une certaine imprécision du positionnement du circuit imprimé, par rapport à la puce, qui se traduit par des difficulté pour réaliser les liaisons avec la puce, surtout quand le dispositif doit être reproduit en grande série.

L'invention a donc pour but de résoudre ce problème de précision de positionnement.

Elle propose à cet effet un procédé d'assemblage de composants sur une plaque de base (par exemple en aluminium argenté), destinée à être implantée dans un dispositif radiofréquence, comprenant :
- une première étape dans laquelle on prévoit une plaque de base munie, en des endroits choisis, de plots saillants définissant entre eux des premières zones de dimensions choisies,
- une deuxième étape dans laquelle on dépose des moyens d'adhésion dans certaines au moins des premières zones,
- une troisième étape dans laquelle on dépose un substrat choisi (par exemple en stratifié Rogers (réf 4003 ou équivalent) ou en tout autre stratifié hyperfréquence (notamment, Arlon, Duroïd, Taconic, Metclad)) dans certaines au moins des premières zones,
- une quatrième étape dans laquelle on applique une pression choisie simultanément sur les substrats de manière à les solidariser à la plaque de base à l'aide des moyens d'adhésion, et
- une cinquième étape dans laquelle on solidarise des composants électroniques (par exemple des MMICs) au sommet de certains au moins des plots, puis on établit des liaisons électriques entre les composants et le(s) substrat(s) situé(s) dans leur voisinage.

Selon l'invention, dans la première étape, on réalise en outre des plots saillants qui définissent entre eux des secondes zones de dimensions choisies en des endroits choisis ; dans la deuxième étape on dépose des moyens d'adhésion dans certaines au moins des secondes zones ; dans la troisième étape on dépose une couche conductrice dans certaines au moins des secondes zones ; dans la quatrième étape on applique la pression choisie sur les substrat(s) et couche(s) conductrice(s), de manière à les solidariser à la plaque de base par l'intermédiaire des moyens d'adhésion ; et dans la cinquième étape on établit des liaisons électriques entre les composants et les couches conductrices situées dans leur voisinage.

Grâce à ce procédé, les couches conductrices sont positionnées avec précision car elles sont guidées, lors de leur mise en place et collage, par les plots saillants, ceux-ci étant usinés ou gravés dans la plaque de base avec un écartement qui laisse juste la place nécessaire pour insérer les couches conductrices.

Les supports des composants électroniques préexistants, il n'y a plus de risque d'étalement de l'adhésif ni de mauvais positionnement des substrats et/ou couches d'alumine. On dispose ainsi d'un procédé dans lequel toutes les opérations peuvent être effectuées par un robot dédié, sans intervention manuelle humaine. Cela permet notamment de réduire notablement les coûts et d'améliorer notablement les rendements de production et la reproductibilité des caractéristiques recherchées.

Préférentiellement, les moyens d'adhésion sont réalisés sous la forme d'un film adhésif muni de perforations permettant le passage des plots en chacun des endroits choisis. Ainsi, le film peut être placé sur la plaque de base en une unique opération. Ce film peut être, par exemple, réalisé dans un matériau de collage à base d'acrylate conductrice chargée de particules métalliques telles que l'argent ou à base d'autres résines conductrices telles que l'epoxy chargée de particules métalliques.

Par ailleurs, certains au moins des composants placés au sommet de plots peuvent être des circuits intégrés hyperfréquence, par exemple de type MMIC, ou des micro-condensateurs, des micro-inductances ou encore des micro-résistances.

Selon une autre caractéristique de l'invention, on applique la pression choisie de préférence à l'aide d'une presse à vide.

Selon encore une autre caractéristique de l'invention, les plots sont de préférence réalisés par usinage ou gravure de la plaque de base. Mais ils pourraient être également obtenus par électro-déposition de métal ou dépôt sous vide, ou par emboutissage (déformation de la plaque de base), ou par frittage, ou encore directement en fonderie avec ou sans reprise d'usinage.

L'invention concerne également un dispositif radiofréquence obtenu directement à l'aide du procédé présenté ci-avant.

Ce dispositif comprend une plaque de base munie, en des endroits choisis, de plots saillants définissant entre eux des premières zones de dimensions choisies, certaines au moins de ces premières zones comportant un substrat choisi solidarisé à la plaque de base par des moyens d'adhésion, après application d'une pression choisie, et certains au moins des sommets des plots supportant des composants électroniques raccordés par des liaisons électriques au(x) substrat(s) situé(s) dans leur voisinage.

Selon l'invention, il comprend en outre des plots saillants définissant également entre eux des secondes zones de dimensions choisies, en des endroits choisis. Certaines au moins des secondes zones peuvent comporter une couche conductrice, par exemple en alumine, solidarisée à la plaque de base par des moyens d'adhésion, par application de la pression choisie, et certains au moins des sommets des plots peuvent supporter des composants électroniques raccordés par des liaisons électriques aux couches conductrices situées dans leur voisinage.
Selon un mode de réalisation préféré, le dispositif comporte des moyens d'adhésion réalisés sous la forme d'un film adhésif muni de perforations permettant le passage des plots en chacun des endroits choisis. Ce film peut être, par exemple, réalisé dans un matériau de collage à base d'acrylate conductrice chargée de particules métalliques telles que l'argent ou à base d'autres résines conductrices telles que l'epoxy chargée de particules métalliques.
Les composants, placés au sommet de plots, pouvent être, pour au moins certains d'entre eux, des circuits intégrés hyperfréquence, par exemple de type MMIC, ou des micro-condensateurs, des micro-inductances ou encore des micro-résistances.

Le dispositif et le procédé selon l'invention sont tout particulièrement adaptés, bien que de façon non exclusive, aux installations de télécommunications hyperfréquence choisies dans un groupe comprenant les installations de type « point à point » et les installations de type « point - multipoints » (qu'il s'agisse d'un « point à multipoint » (ou « multicast ») ou d'un « multipoint à point » (ou « concast »)).

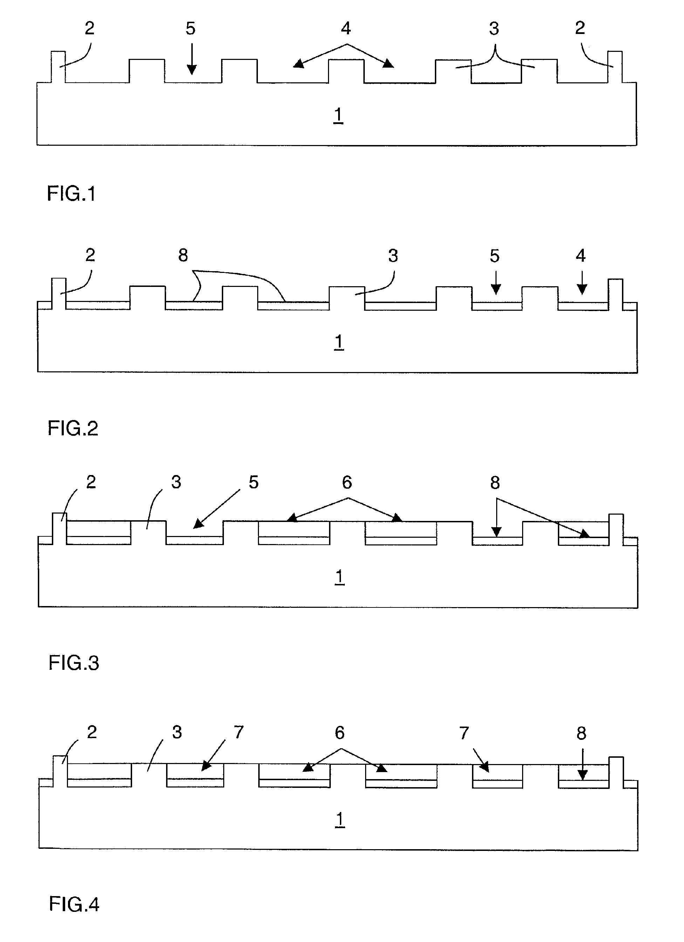

D'autres caractéristiques et avantages de l'invention apparaîtront à l'examen de la description détaillée ci-après, et des dessins annexés, sur lesquels les figures 1 à 7 illustrent de façon schématique les états successifs d'une plaque de base, vue en coupe transversale, après mise en oeuvre des étapes successives du procédé selon l'invention.

Les dessins annexés sont, pour l'essentiel, de caractère certain. En conséquence, ils pourront non seulement servir à compléter l'invention, mais aussi contribuer à sa définition, le cas échéant.

Dans la description qui suit il sera fait référence à l'assemblage de composants sur une plaque de base 1, métallique, destinée à être implantée, une fois assemblée, dans un terminal radio d'une installation de télécommunications, de type « point à point » ou « point - multipoint ».

Comme illustré sur la figure 1, le procédé selon l'invention consiste tout d'abord à prendre une plaque de base (ou « soleplate ») 1, par exemple en aluminium argenté ou en alliage cuivreux doré, et à former dans cette plaque des plots saillants 2 et 3, en des endroits définis par un modèle prédéfini, par exemple par usinage ou gravure ou par électro-déposition de métal, ou dépôt sous vide, ou par emboutissage (déformation de la plaque de base), ou par frittage, ou encore directement en fonderie avec ou sans reprise d'usinage. Bien entendu, le modèle peut varier selon les besoins et les caractéristiques recherchées.

Ces plots 2 et 3 permettent de définir entre eux des premières 4 et secondes 5 zones destinées respectivement à recevoir des substrats 6 et des couches conductrices 7, comme on le verra plus loin en référence aux figures 3 et 4.

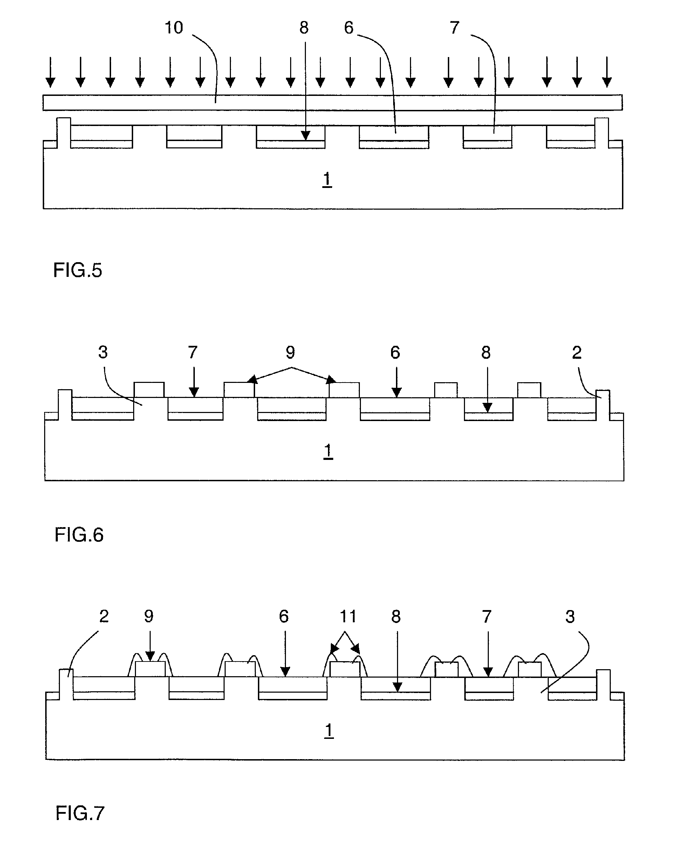

Préférentiellement, deux types de plots sont prévus. Un premier type de plots 2 est formé aux extrémités de la plaque de base 1 pour faciliter le positionnement d'un adhésif 8 comme on le verra plus loin en référence à la figure 2. Un second type de plots 3 est formé dans la partie centrale de la plaque de base 2 pour recevoir les composants électroniques 9, comme on le verra plus loin en référence à la figure 6. A cet effet, les seconds plots 3 possèdent une face supérieure sensiblement plate.

La hauteur des premiers plots 2 est supérieure à la hauteur des seconds plots 3, pour faciliter l'opération de positionnement de l'adhésif 8. Par ailleurs, les plots 2 et 3 présentent, de préférence, une forme sensiblement parallélépipédique. Mais, d'une façon générale, les formes et dimensions des différents plots sont choisies en fonction des caractéristiques recherchées, et par conséquent des formes et dimensions des différents substrats 6, des différentes couches conductrices 7 et des différents composants électroniques 9 à assembler.

Dans une deuxième étape du procédé, illustrée sur la figure 2, on place un adhésif 8 sur la plaque de base, et plus précisément dans les premières 4 et secondes 5 zones définies par les plots 2 et 3. Préférentiellement, l'adhésif 8 est un film perforé selon le modèle choisi pour les plots 2 et 3. A l'aide d'un robot dédié, par exemple, on approche le film 8 de la plaque de base 1 jusqu'à ce que ses perforations d'extrémité soient traversées par les premiers plots de guidage. Ensuite, on pousse le film 8 jusqu'à ce que ses perforations centrales soient traversées par les seconds plots 3, puis que ledit film soit sensiblement au contact des premières 4 et secondes 5 zones définies à la surface de la plaque de base 1. Ainsi, en une unique opération on peut placer le film 8 sur la plaque de base 1.

Préférentiellement, le film 8 est à base de colle acrylate.

On pourrait envisager que le film comprenne des perforations supplémentaires, de sorte que certaines premières et/ou secondes zones ne reçoivent pas d'adhésif.

Bien entendu, au lieu d'utiliser un film adhésif, on pourrait utiliser de la colle, celle-ci étant alors déposée séquentiellement, portion après portion, dans les différentes zones 4 et 5.

Dans une troisième étape du procédé, illustrée sur les figures 3 et 4, on positionne un substrat 6 dans chacune des premières zones 4 munies d'adhésif 8 et une couche conductrice 7 dans chacune des secondes zones 5 munies d'adhésif 8. Préférentiellement, cette étape s'effectue en deux sous-étape illustrées respectivement sur les figures 3 et 4, la première sous-étape consistant à placer simultanément les substrats 6 dans les premières zones 4 et la seconde sous-étape consistant à placer simultanément les couches conductrices 7 dans les secondes zones 5.

Les substrats 6 sont de préférence des circuits imprimés gravés en stratifié Rogers (réf 4003 ou équivalent) ou en tout autre stratifié hyperfréquence comme par exemple Arlon, Duroïd ,Taconic , Metclad, qui assurent des fonctions d'interconnexions adaptées en impédance, et/ou de filtrage hyper frequence, et/ou de transition à guide d'onde hyperfréquence (plus connues sous l'acronyme anglais MWT, pour « Microwave Waveguide Transition »).

Les substrats 6 ne sont pas tous nécessairement identiques. On pourrait en effet envisager que plusieurs types de substrats soient déposés dans les différentes premières zones 4. Ces substrats 6 pourraient notamment différer de par leurs dimensions et/ou composition.

Les couches conductrices 7 sont de préférence des plaques d'alumine portant, sur leur face libre, un dépôt métallique alumine. Elles sont destinées à permettre, quand cela est nécessaire, la réalisation de fonctions hyperfréquences complexes non réalisables sur les substrats. Elles sont connectées aux composants électriques 9, comme on le verra plus loin en référence à la figure 7. Bien entendu, d'autres types de couches conductrices pourraient être utilisés.

Les couches conductrices 7 ne sont pas toutes nécessairement identiques. On pourrait en effet envisager que plusieurs types de couches soient déposés dans les différentes secondes zones 5. Ces couches 7 pourraient notamment différer de par leurs dimensions et/ou composition.

Dans une quatrième étape du procédé, illustrée sur la figure 5, on procède à la solidarisation à la plaque de base 1 des substrats 6 et couches 7 précédemment déposés dans les premières 4 et secondes 5 zones.

Pour ce faire, on utilise des moyens de pression 10, tels qu'une presse à vide capable d'appliquer des pressions de l'ordre de 6 bars. Préférentiellement, on utilisera une presse à vide massique, sous azote. Plus préférentiellement encore, les plaques de base 1, équipées des substrats 6 et couches conductrices 7 précédemment déposés dans les premières 4 et secondes 5 zones, sont recouvertes de plusieurs couches de feutres de compensation de niveaux (ces feutres absorbent la différence de hauteur entre les différents plots 2 et 3, les substrats 6 et les couches conductrices 7). L'ensemble ainsi constitué est recouvert d'un moule, comme par exemple une plaque d'acier plane d'environ 10 mm, puis placé dans un sachet étanche où est fait le vide. On le place ensuite dans la presse où une mise sous pression d'azote de l'ordre de 6 bars accompagnée d'un cycle de température assure la solidarisation de la plaque de base 1 aux substrats 6 et couches conductrices 7. Les gaz de polymérisation sont évacués par un maintien sous-vide (aspiration) du sachet étanche pendant le pressage.

L'azote à environ 6 bars permet d'appliquer une pression sensiblement homogène sur l'ensemble des substrats 6 et couches conductrices 7, et par conséquent d'obtenir en une unique opération une solidarisation de qualité.

De très nombreuses plaques de base 1, typiquement plusieurs centaines, peuvent ainsi être traitées en parallèle, simultanément.

En variante, on peut assurer la solidarisation à l'aide d'une presse à plateau chauffant classique.

Dans une cinquième et dernière étape du procédé, illustrée sur les figures 6 et 7, on dépose tout d'abord un adhésif sur les faces supérieures de certains au moins des seconds plots 3, afin d'y fixer des composants électroniques 9, puis on établit des liaisons électriques 11 entre les composants électroniques 9 et les substrats 6 et/ou couches conductrices 7 situés dans leur voisinage.

Préférentiellement, cette cinquième étape se décompose en trois sous-étape successives, la première consistant à déposer de la colle conductrice en pâte, préférentiellement par « distribution à l'aide d'une machine automatisée, la seconde consistant à déposer les composants électroniques 9 à l'aide d'une machine de pose automatique, par exemple de type « pick and place », et la troisième consistant à réaliser les connexions électriques 11.

Généralement, les composants électroniques 9 sont des circuits intégrés hyperfréquence millimétriques, de type MMIC ayant des fonctions d'amplification hyperfréquence et/ou d'autres fonctions électroniques complexes, et auxquels on peut associer d'autres composants tels que des micro-condensateurs, des micro-inductances ou des micro-résistances.

Les composants électroniques 9 ne sont pas tous nécessairement identiques. On pourrait en effet envisager que plusieurs types de composants soient déposés au sommet des seconds plots 3. Ces composants 9 pourraient notamment différer de par leurs dimensions et/ou fonctions.

Tout comme les autres étapes, cette cinquième étape peut être mise en oeuvre par un robot dédié, par exemple.

Grâce au procédé selon l'invention, on peut réaliser en parallèle un grand nombre de dispositifs radiofréquence, du type de celui illustré schématiquement sur la figure 7, et de préférence identiques (c'est-à-dire présentant un même modèle initial et des composants de mêmes types). Comme indiqué précédemment, ce type de dispositif peut notamment être implanté dans un terminal ou station de base radio d'une installation de télécommunications de type « point à point » ou « point - multipoint ».

Ce dispositif radiofréquence comporte une plaque de base métallique 1 munie, en des endroits choisis, de plots saillants 2 et 3 qui définissent entre eux des premières 4 et secondes 5 zones de dimensions choisies. Certaines au moins de ces premières 4 et secondes 5 zones comportent respectivement un substrat 6 choisi et une couche conductrice 7 solidarisée à la plaque de base 1 via des moyens d'adhésion 8, après application d'une pression choisie. Par ailleurs, certains au moins des sommets des plots 3 supportent des composants électroniques 9 raccordés par des liaisons électriques 11 aux substrats 6 et/ou couches conductrices 7 situés dans leur voisinage.

Ce dispositif pouvant être mis en oeuvre à l'aide du procédé présenté ci-avant, tout ce qui a été dit en référence audit procédé s'applique également à lui.

L'invention ne se limite pas aux modes de réalisation de dispositif et de procédé décrits ci-avant, seulement à titre d'exemple, mais elle englobe toutes les variantes que pourra envisager l'homme de l'art dans le cadre des revendications ci-après.

Ainsi, on a décrit une plaque de base équipée de plots définissant entre eux des premières et secondes zones pour recevoir des substrat(s) et couche(s) conductrice(s). Mais, les secondes zones pourraient être laissées inoccupées ou masquées, la plaque de base ne recevant alors qu'un ou plusieurs substrats dans ses premières zones. Les plots pourraient également ne définir entre eux que des premières zones pour ne recevoir qu'un ou plusieurs substrats.

Par ailleurs, on peut envisager d'intégrer la plaque de base et les plots directement dans le boîtier contenant l'étage final radiofréquence, qu'ils soient réalisés en fonderie, avec ou sans reprise d'usinage, ou bien usinés.

## Revendications

1. Procédé d'assemblage de composants sur une plaque de base
(1) destinée à être implantée dans un dispositif radiofréquence, comprenant :
• une première étape dans laquelle on prévoit une plaque de base (1) munie, en des endroits choisis, de plots saillants (2,3) définissant entre eux au moins des premières zones (4) de dimensions choisies,
• une deuxième étape dans laquelle on dépose des moyens d'adhésion (8) dans certaines au moins desdites premières zones (4),
• une troisième étape dans laquelle on dépose des substrats choisis (6) dans certaines au moins desdites premières zones (4),
• une quatrième étape dans laquelle on applique une pression choisie sur lesdits substrats (6), de manière à les solidariser à la plaque de base (1) par l'intermédiaire desdits moyens d'adhésion (8), etune cinquième étape dans laquelle on solidarise des composants électroniques (9) au sommet de certains au moins desdits plots (2,3), puis on établit des liaisons électriques (11) entre lesdits composants (9) et les substrats (6) situés dans leur voisinage ;
**caractérisé**
• **en ce que** dans la première étape lesdits plots saillants (2,3) définissent également entre eux des secondes zones (5) de dimensions choisies en des endroits choisis,
• en ce que dans la deuxième étape on dépose des moyens d'adhésion (8) dans certaines au moins desdites secondes zones (5),
• en ce que dans la troisième étape on dépose une couche conductrice (7) dans certaines au moins desdites secondes zones (5),
• en ce que dans la quatrième étape on applique ladite pression choisie sur lesdits substrat(s) (4) et couche(s) conductrice(s) (7), de manière à les solidariser à la plaque de base (1) par l'intermédiaire desdits moyens d'adhésion (8),
• et en ce que dans la cinquième étape on établit des liaisons électriques (11) entre lesdits composants (9) et les couches conductrices (7) situées dans leur voisinage.

2. Procédé selon la revendication 1, **caractérisé en ce que** lesdits moyens d'adhésion (8) sont un film adhésif muni en lesdits endroits choisis de perforations pour le passage desdits plots (2,3).

3. Procédé selon la revendication 2, **caractérisé en ce que** le film adhésif (8) est réalisé dans un matériau de collage à base d'acrylate.

4. Procédé selon l'une des revendications 1 à 3, **caractérisé en ce que** ladite couche conductrice (7) est en alumine.

5. Procédé selon l'une des revendications 1 à 4, **caractérisé en ce que** ledit substrat (6) est un stratifié hyperfréquence choisi dans un groupe comprenant au moins le stratifié Rogers, l'Arlon, le Duroïd ,le Taconic et le Metclad.

6. Procédé selon l'une des revendications 1 à 5, **caractérisé en ce que** certains au moins desdits composants (9) sont des circuits intégrés hyperfréquence.

7. Procédé selon la revendication 6, **caractérisé en ce que** lesdits circuits (9) sont de type MMIC.

8. Procédé selon l'une des revendications 1 à 7, **caractérisé en ce que** l'on applique ladite pression choisie à l'aide d'une presse à vide (10).

9. Procédé selon l'une des revendications 1 à 8, **caractérisé en ce que** lesdits plots (2,3) sont réalisés dans la plaque de base (1) à l'aide d'une technique choisie dans un groupe comprenant l'usinage, la gravure, l'électro-déposition de métal, le dépôt sous vide, l'emboutissage, le frittage, la fonderie.

10. Procédé selon l'une des revendications 1 à 9, **caractérisé en ce qu'**il comprend au moins des premiers (2) et des seconds (3) plots présentant des première et seconde hauteurs, lesdits composants électroniques étant placés au sommet desdits seconds plots (3).

11. Dispositif radiofréquence, comprenant une plaque de base (1) munie, en des endroits choisis, de plots saillants (2,3) définissant entre eux au moins des premières zones (4) de dimensions choisies, certaines au moins de ces premières zones (4) comportant un substrat choisi (6) solidarisé à ladite plaque de base (1) par des moyens d'adhésion (8), par application d'une pression choisie, et certains au moins des sommets desdits plots supportant des composants électroniques (9) raccordés par des liaisons électriques (11) aux substrats (6) situés dans leur voisinage.
**caractérisé en ce que** lesdits plots saillants (2,3) définissent également entre eux des secondes zones (5) de dimensions choisies, en des endroits choisis ;et **en ce que** certaines au moins desdites secondes zones (5) comportent une couche conductrice (7) solidarisée à ladite plaque de base (1) par des moyens d'adhésion (8), par application de ladite pression choisie, et certains au moins des sommets desdits plots supportent des composants électroniques (9) raccordés par des liaisons électriques (11) aux couches conductrices (7) situées dans leur voisinage.

12. Dispositif selon la revendication 11, **caractérisé en ce que** lesdits moyens d'adhésion (8) sont un film adhésif muni en lesdits endroits choisis de perforations pour le passage desdits plots.

13. Dispositif selon la revendication 12, **caractérisé en ce que** le film adhésif (8) est réalisé dans un matériau de collage à base d'acrylate.

14. Dispositif selon l'une des revendications 11 à 13, **caractérisé en ce que** ladite couche conductrice (7) est en alumine.

15. Dispositif selon l'une des revendications 11 à 14, **caractérisé en ce que** ledit substrat (6) est un stratifié hyperfréquence choisi dans un groupe comprenant au moins le stratifié Rogers, l'Arlon, le Duroïd ,le Taconic et le Metclad.

16. Dispositif selon l'une des revendications 11 à 15, **caractérisé en ce que** certains au moins desdits composants (9) sont des circuits intégrés hyperfréquence.

17. Dispositif selon la revendication 16, **caractérisé en ce que** lesdits circuits (9) sont de type MMIC.

18. Dispositif selon l'une des revendications 11 à 17, **caractérisé en ce que** lesdits plots (2,3) sont réalisés dans la plaque de base (1) à l'aide d'une technique choisie dans un groupe comprenant l'usinage, la gravure, l'électro-déposition de métal, le dépôt sous vide, l'emboutissage, le frittage, la fonderie.

19. Dispositif selon l'une des revendications 11 à 18, **caractérisé en ce qu'**il comprend au moins des premiers (2) et des seconds (3) plots présentant des première et seconde hauteurs, lesdits composants électroniques (9) étant placés au sommet desdits seconds plots (3).

20. Utilisation du dispositif et du procédé selon l'une des revendications précédentes, dans les unités terminales radiofréquence d'installation de télécommunications.

21. Utilisation selon la revendication précédente, dans les installations de télécommunications hyperfréquence choisies dans un groupe comprenant les installations de type « point à point » et les installations de type « point - multipoints ».
